# EUROPÄISCHE PATENTANMELDUNG

(11) **EP 2 184 818 A1**
(43) Veröffentlichungstag der Anmeldung: **12.05.2010**
(21) Anmeldenummer: 08168736.0
(22) Anmeldetag: 10.11.2008
(51) Int. Cl.: H01S 3/0941, G02B 27/09, H01S 3/06

(54) **Laserpumpanordnung und Laserpumpverfahren mit Strahlhomogenisierung**

(71) Anmelder: High Q Technologies GmbH, 6832 Röthis (AT); Kopf, Daniel, 6832 Röthis (AT)
(72) Erfinder: Kopf, Daniel, A-6832 Röthis (AT); Lederer, Maximilian, A-6861 Alberschwende (AT)
(74) Vertreter: Kaminski Harmann

(57) **Zusammenfassung**

In einer Laserpumpanordnung für ein Laserstrahlung verstärkendes Lasermedium mit mindestens einer Laser-Pumpquelle (1'') mit mehreren Emittern zur Erzeugung von Teilpumpstrahlen (TPS1'' ,TPS2'') werden durch eine Einkopplungsoptik die Teilpumpstrahlen (TPS1'',TPS2'') in einen Homogenisator (3'') geführt und dort in einer Achse durch multiple Reflexionen durchmischt. Hierbei sind Homogenisator (3'') und Lasermedium so ausgebildet und angeordnet, dass der aus dem Homogenisator (3'') austretende Pumpstrahl unter Divergenzerhaltung in der Durchmischungsachse (DA) unmittelbar auf oder in das Lasermedium geführt wird, wobei die Teilpumpstrahlen (TPS1'',TPS2'') in einer zur Durchmischungsachse (DA) senkrechten Projektionsachse (PA) direkt auf oder in das Lasermedium projiziert, insbesondere fokussiert werden.

## Beschreibung

Die Erfindung betrifft eine Laserpumpanordnung für ein Laserstrahlung verstärkendes Lasermedium nach dem Oberbegriff von Anspruch 1, ein damit ausgestattetes Lasersystem und ein Laserpumpverfahren für ein Laserstrahlung verstärkendes Lasermedium nach dem Oberbegriff des Anspruchs 14.

Diodengepumpte Festkörperlaser stellen Standardlasersysteme dar, die in vielfältigen Anwendungen zum Einsatz kommen. Eine Leistungsskalierung geschieht dabei in der Praxis unter Verwendung verschiedener Techniken. Das Grundproblem besteht in der Regel darin, dass bei zunehmender volumetrischer Pumpleistungsdichte im Lasermedium thermisch ausgelöste Effekte, wie z.B. thermische Linsen, Depolarisationen oder Spannungsbrüche, zur Degradation der Strahlparameter bzw. zur Zerstörung des Lasermediums führen. Zudem treten verstärkt Aberrationen der Lasermode auf, wenn Hochleistungspumpquellen, welche für die Leistungsskalierung benötigt werden, nur mangelhafte Homogenisierung aufweisen.

Eine Skalierung durch Vergrösserung des annähernd runden Pumpquerschnittes ist zwar begrenzt möglich, führt aber schnell zu Schwierigkeiten bei der Anpassung der Lasermode.

Aus dem Stand der Technik sind daher verschiedene andere Ansätze bekannt, mit denen eine Leistungsskalierung angestrebt wird, welche diese negativen Effekte vermeiden oder zumindest vermindern.

Eine weitaus bessere Methode der Skalierung bietet z. B. das Konzept des Scheibenlasers mit runder mehrfach in das Lasermedium rückgeführter Pumpe, wie es beispielsweise in der EP 0 632 551 dargestellt wird. Hierbei werden thermischen Effekte mit einem direkten Ansatz verringert, indem das Lasermedium sehr dünn gestaltet und die Kühlung eindimensional in Richtung der dünnen Ausdehnung des Lasermediums durchgeführt wird.

Die hierdurch erreichten Vorteile bestehen darin, dass zum einen eine sehr geringe Temperaturüberhöhung aufgrund der Nähe des Kühlkörpers resultiert, zum anderen bleiben die Quer-Gradienten über die Lasermode gering, da nur vernachlässigbare Wärmeleitung in diese Richtung erfolgt.

Eine Weiterführung dieses Gedankens wird in der EP 1 629 576 beschrieben. Hier wird durch die Verwendung einer stark elliptisch fokussierten Pumpanordnung in die Scheibe ein zusätzlicher thermischer Vorteil durch einen zweidimensionalen Wärmefluss erreicht, welcher sich in einer geringeren Spitzentemperatur auswirkt.

Durch die Fortschritte im Bereich der fasergekoppelten Laserdioden konnte eine kontinuierliche Erhöhung der Brillanz solcher Strahlquellen erreicht werden, was dazu genutzt werden kann, die Skalierung über die Länge des Lasermediums zu erreichen. Speziell in Zusammenhang mit Lasermedien mit vergleichsweise hohen Verstärkungsquerschnitten, wie z.B. Nd:Vanadate, werden mit äusserst einfachen Aufbauten sehr gute Erfolge erzielt. Die Fortschritte, welche in den letzten 10-20 Jahren in der Kristallwachstumstechnologie erzielt wurden haben sich hier ebenso positiv ausgewirkt. Eine konsequente Weiterführung dieses Konzeptes führt schliesslich zum Faserlaser, welcher, ähnlich wie der Scheibenlaser, sehr hohe Ausgangsleistungen ermöglicht.

Schliesslich besteht eine weitere Möglichkeit der Leistungsskalierung im sog. elliptischen bzw. stark elliptischen Pumpen. Dabei wird ein starker Fokus, z. B. in der vertikalen Richtung, aufrecht erhalten, um die nötige Kleinsignalverstärkung zu gewährleisten. Hingegen wird das gepumpte Volumen durch eine Verbreiterung in der anderen Richtung vergrössert. Hierbei wird sichergestellt, dass die flächenmässige Leistungsdichte nicht über den für thermische Effekte kritischen Wert steigt. Ein entsprechender Ansatz ist beispielsweise aus der EP 1 318 578 bekannt. Eine Skalierung wird damit durch die Verbreiterung der Linie erreicht. Die für diesen Ansatz am besten geeignete Geometrie des Lasermediums ist ein Stab bzw. "Slab", wie er auch in der EP 1 181 754 beschrieben wird. Besonders wichtig in diesem Zusammenhang ist eine sehr homogene Pumpverteilung entlang der Linie, da bei Inhomogenitäten sehr schnell Aberrationen in der Lasermode auftreten. Dies kann bspw. dadurch gelöst werden, dass das Licht von einem Laserbarrenstapel mittels einer Mehrzahl von Linsen zuerst über einen Homogenisator mit totaler interner Reflexion an zwei Seiten als planarem Wellenleiter geführt wird, dessen Austrittsfläche dann wieder über eine Mehrzahl von Linsen in bzw. auf das Lasermedium abgebildet wird. Eine solche Ver- oder Durchmischung verringert den Einfluss von ausfallenden oder sich in ihrer Leistung verändernder Pumpstrahlquellen, so dass ein homogener bzw. homogenisierter Pumpstrahl folgt, der als Pumplichtfleck auf das Lasermedium abgebildet wird.

Dieser Ansatz erlaubt somit zwar eine Durchmischung der Emissionen verschiedener Laserdioden im Stapel, ist jedoch aufgrund der verwendeten Linsensysteme bei der Ein- und Auskopplung in den Homogenisator aufwendig in Aufbau und Justierung. Zudem resultieren aus den nachgeordneten Optiken entsprechende Anforderungen an den Platzbedarf des Lasersystems

Gattungsgemässe Lasersysteme mit Homogenisatorstäben des Stands der Technik sind somit durch ihren Aufbau und die verwendeten Komponenten zu komplex, justieraufwendig und/oder zu gross.

Andere Ansätze, wie sie beispielsweise in Beach, Raymond J.: "Theory and optimization of lens ducts", Applied Optics, Vol. 35, No. 12, 20. April 1996, Seiten 2005-2015 oder Honea, Eric C. et al.: "Analysis of an intracavitydoubled diode-pumped Q-switched Nd:YAG laser producing more than 100 W of power at 0.352 µm", Optics Letters, Vol. 23, No. 15, 1. August 1998, Seiten 1203-1205 beschrieben werden, verzichten zwar auf eine dem Homogenisator nachgeschaltete Optik, eignen sich aber aufgrund der für die beschriebenen Anwendungen erforderlichen Durchmischung in zwei Achsen nicht zur Erzeugung von hochelliptischen Pumpfleckgeometrien.

Eine Aufgabe der vorliegenden Erfindung besteht in der Bereitstellung einer kompakteren oder vereinfachten Laserpumpanordnung zur Erzeugung elliptischer Pumpgeometrien sowie eines diese verwendenden Lasersystems, insbesondere eines diodengepumpten Festkörperlasersystems. Eine weitere Aufgabe besteht in der Bereitstellung eines solchen Lasersystems, welches eine verbesserte Robustheit und verminderten Justieraufwand aufweist.

Diese Aufgaben werden durch die Gegenstände der Ansprüche 1 und 14 oder der abhängigen Ansprüche gelöst bzw. die Lösungen weitergebildet.

Die Erfindung betrifft eine Pumpanordnung bzw. ein Pumpverfahren für Lasermedien, bei denen die Teilstrahlen einer Mehr- oder Vielzahl von Pumpstrahlquellen gesammelt, vermischt und als Pumpstrahl zur Erzeugung elliptischer Pumpgeometrien auf oder in ein verstärkendes Lasermedium geführt werden. Der Querschnitt des zu erzielenden elliptischen Pumplichtflecks wird hierbei durch das Aspektverhältnis beschrieben, wobei hier Verhältnisse von Pumplichtfleck-Länge zu -Breite von beispielsweise > 3:1, insbesondere > 15:1 oder noch höher erzielt werden.

Die erfindungsgemässe Lösung für das homogenisierte Pumpen eines Lasermediums stellt im wesentlichen ein platzoptimiertes System dar, welches mit einer Minimalzahl von Standardlinsen zuzüglich eines Homogenisators aufgebaut werden kann. Durch die im Vergleich zum Stand der Technik kleinere Zahl von Linsen verringern sich Platzbedarf und Justieraufwand.

Im Detail wird auf die optische Abbildung des Homogenisatorausgangs in das Lasermedium verzichtet. Statt dessen werden beide in unmittelbare Nähe angeordnet, z.B. mit einem Abstand von 100-300µm positioniert, so dass das Pumplicht ohne Abbildung eines eigentlichen Pumplichtflecks und mit bestimmtem Querschnitt unter Divergenzerhaltung, abgesehen von der Brechung an planen Oberflächen, im wesentlichen im Lasermedium weitergeführt wird. Das Lasermedium stellt damit funktional eine Verlängerung des Homogenisators dar, wobei der Homogenisator strahlformende Wirkung aufweist und an seinem Ausgang einen Strahl mit dem gewünschten Querschnitt bzw. Strahlprofil bereitgestellt. Im Vergleich zu Anordnungen mit abbildenden Komponenten wird somit die Funktion der Strahlformung durch eine nachgeordnete Linse bereits durch den Homogenisator und dessen Zusammenspiel mit einer Einkopplungsoptik bewirkt.

Der Homogenisator als planarer optischer Wellenleiter kann dabei polierte oder auch beschichtete bzw. verspiegelte Seitenflächen haben, um das Führen durch totale interne Reflexion zu ermöglichen. Die Dimensionen des Homogenisators werden dabei so gewählt, dass in Richtung der Durchmischung die erforderliche Breite des Pumpstrahls im Lasermedium entsteht und die Durchmischung ausreichend vollständig ist, d.h. unterhalb einer Toleranzschwelle für Abweichung vom Sollprofil des homogenen Verlaufs bleibt. Da in den meisten Lasersystemen eine lineare Abfolge von Laserdioden in Form von Laserbarren oder -zeilen verwendet werden, erfolgt eine Durchmischung der durch diese Anordnung bedingten und räumlich versetzten Teilstrahlbündel in einer Achse. Hierdurch wird der Einfluss der unterschiedlichen Entstehungsorte eliminiert bzw. unter eine vorgegebene Schwelle gedrückt.

Eine Voraussetzung für die gewünschte Durchmischung ist die hierfür optimierte Einkopplung der Teilstrahlen in das homogenisierende Element, was durch die Wahl von in Durchmischungsrichtung geeigneter zylindrischer Einkoppellinsen möglich ist. Divergenz und Länge des Homogenisators stehen hierbei in einem Abhängigkeitsverhältnis, d.h. eine hohe Divergenz ermöglicht einen kurzen Homogenisator wohingegen eine geringe Divergenz einen langen Homogenisator erfordert. Die bei hoher Divergenz entstehenden grossen Ein- und Austrittswinkel sowie die damit einhergehenden Reflexionsverluste können mit geeigneten Schichtsystemen sowohl auf dem Homogenisator als auch auf dem Lasermedium minimiert werden.

Bei den üblicherweise verwendeten Laserdioden erfolgt bereits emitterseitig eine Kollimierung in der Fast-axis. Diese wird durch eine nach der Pumpquelle angeordnete zylindrische Linse wieder fokussiert. Die angestrebten Fokussierungen, z.B. dy = 100 - 880 µm, lassen sich hiermit ohne weiteres erreichen.

Durch diese Anordnung entsteht am Ende des Homogenisators und vor dem Lasermedium, d.h. am Übergang dieser beiden Komponenten, ein homogenes Strahlungsfeld mit allerdings hoher Divergenz in der Homogenisierungsrichtung. Der Verzicht auf eine dem Homogenisator nachgeordnete Strahlformung, z.B. in Form weiterer Linsen, kann beispielsweise durch eine die Transmission optimierende Beschichtung unterstützt werden, wobei auch bei den auftretenden grossen Winkeln eine hohe Transmission gewährleistet sein muss.

Ggf. kann die Strahlführung des durch das Lasermedium zu verstärkenden Laserlichts von der gegenüberliegenden Seite her erfolgen, so daß die Verbindung Medium - Stab für das Pumplicht höchst transmittiv, für das Laserlicht aber reflektierend ausgebildet sein kann - z.B. durch spektral selektives Coating. Ausserdem soll dieses auch für den vollen Winkelbereich der Divergenz, z.B. bis 60°, durchlässig sein, also eine hohe Transmission für einen großen Einfallswinkelbereich ermöglichen.

Durch diese Anordnung der beiden Komponenten wird bewirkt, dass eine fortlaufende Strahlführung vom Homogenisator in das Lasermedium erreicht wird, wobei beide Komponenten miteinander verbunden, d.h. in Kontakt miteinander stehen, oder aber mit geringem Abstand positioniert sind. Dieser Abstand wird durch die im Lasermedium zu erzielende Pumpwirkung, d.h. die Breite der Pumpstrahllinie bedingt. In Abhängigkeit von den Eigenschaften des durchmischten Strahls im Homogenisator, d.h. insbesondere dessen dort erzeugten Strahlquerschnitt und dessen Strahldivergenz, kann dann der Abstand gewählt werden. Im Gegensatz zur Verwendung von Optiken zwischen Homogenisator und Lasermedium wird der Strahl unmittelbar weitergeführt, so dass keine weiteren, die Strahlcharakteristik verändernden Elemente zwischen den Komponenten angeordnet sind. Dies betrifft insbesondere die Bewahrung der am Ausgang des Homogenisators vorliegenden Strahldivergenz. In diesem Sinne erfolgt eine direkte Fortführung des Strahlgangs ohne Beeinflussung der Strahlcharakteristik von Homogenisator zu Lasermedium. Dies wird im Falle einer direkten Kontaktierung mit fixierender und transmissionsoptimierender Verbindung beider Komponenten klar, die z.B. durch Kitten oder Diffusionsbonding erzielt werden kann. Homogenisator und Lasermedium bilden somit einen zusammenhängenden planaren Wellenleiter, der ggf. in einigen Ausführungsformen durch eine schmalen, aber die Divergenz bewahrenden Freistrahlungsbereich unterbrochen sein kann.

Durch diese direkte Strahlfortführung kann es erforderlich werden, im Lasermedium eine Divergenzkompensation durchzuführen, welche beispielsweise durch hochpolierte oder beschichtete seitliche Flächen des Mediums möglich ist.

Senkrecht zur Durchmischungsachse wird die Teilpumpstrahlung eines Emitters entweder direkt und ohne Beeinflussung der Divergenz oder aber mittels Fokussierung durch den Homogenisator geführt, d.h. dieser durchmischt nur in einer Achse, wohingegen in der anderen Achse keine Durchmischung sondern eine direkte Projektion auf das Lasermedium erfolgt. Die Kombination von hoher Divergenz in der Durchmischungsachse und geringer Divergenz bzw. ggf. Fokussierung in der Projektionsachse bewirkt einen hochelliptischen Strahlquerschnitt des Pumplichts.

Die erfindungsgemässe Pumpanordnung bzw. das erfindungsgemässe Pumpverfahren werden nachfolgend anhand von in der Zeichnung schematisch dargestellten Ausführungsbeispielen rein beispielhaft näher beschrieben oder erläutert. Im einzelnen zeigen
- Fig.1A-C: die schematische Darstellung eines ersten Ausführungsbeispiels der erfindungsgemässen Pumpanordnung;
- Fig.2A-E: die schematische Darstellung eines zweiten Ausführungsbeispiels der erfindungsgemässen Pumpanordnung mit Varianten einer Fokussierung in der Projektionsachse;
- Fig.3: die schematische Darstellung eines dritten Ausführungsbeispiels der erfindungsgemässen Pumpanordnung;
- Fig.4: die schematische Darstellung eines vierten Ausführungsbeispiels der erfindungsgemässen Pumpanordnung;
- Fig.5: die schematische Darstellung eines fünften Ausführungsbeispiels der erfindungsgemässen Pumpanordnung;
- Fig.6: die schematische Darstellung eines sechsten Ausführungsbeispiels der erfindungsgemässen Pumpanordnung;
- Fig.7A-B: die schematische Darstellung eines siebten Ausführungsbeispiels der erfindungsgemässen Pumpanordnung;
- Fig.8: die schematische Darstellung eines achten Ausführungsbeispiels der erfindungsgemässen Pumpanordnung;
- Fig.9A-D: die Darstellung eines ersten Beispiels für den Strahlgang der erfindungsgemässen Pumpanordnung;
- Fig.10A-D: die Darstellung eines zweiten Beispiels für den Strahlgang der erfindungsgemässen Pumpanordnung und
- Fig.11A-B: die schematische Darstellung eines achten Ausführungsbeispiels der erfindungsgemässen Pumpanordnung.

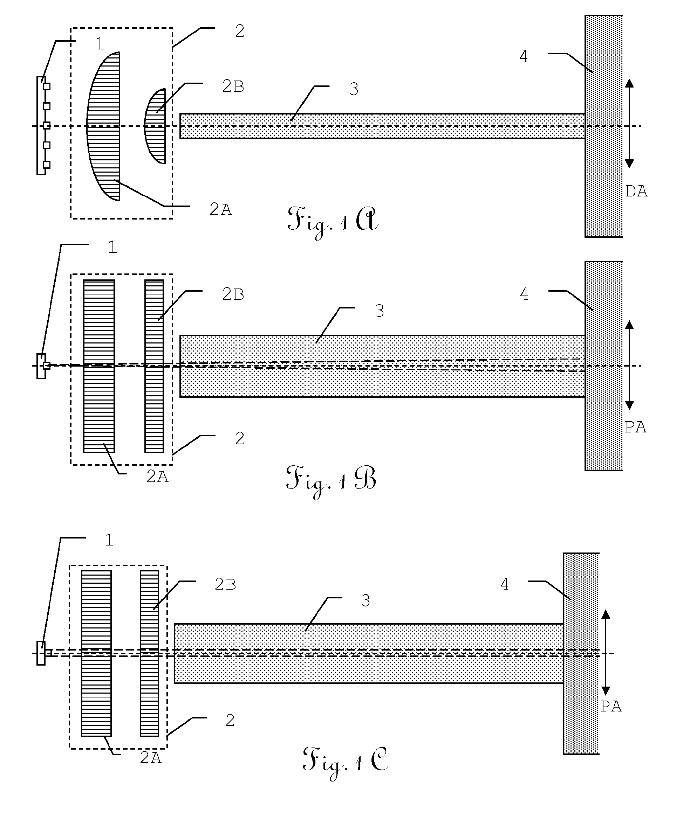

Fig.1A-B zeigt die schematische Darstellung eines ersten Ausführungsbeispiels der erfindungsgemässen Pumpanordnung, wobei Fig.1A eine Drauf- und Fig.1B und Fig. 1C jeweils eine Seitenansicht für unterschiedliche Divergenzen der emittierten Pumpstrahlung darstellen.

Die Pumpanordnung für ein Laserstrahlung verstärkendes Lasermedium weist mindestens eine Laser-Pumpquelle 1 mit mehreren Elementen zur Erzeugung von Teilpumpstrahlen auf. Hierbei werden zumeist Laserdioden verwendet, die übereinander oder nebeneinander angeordnet sind und deren Laserstrahlung zum Pumpen des Lasermediums 4 Verwendung findet.

Die von dieser Laser-Pumpquelle 1 emittierten Teilstrahlenbündel werden in einem der Laser-Pumpquelle 1 nachgeordneten optischen Homogenisator 3 in einer Durchmischungsachse DA durchmischt. Dieser weist in diesem Ausführungsbeispiel als Homogenisatorstab einen rechteckigen Querschnitt auf, wobei dessen Dimensionierung genauso wie die Länge des Stabes sowohl von der Laser-Pumpquelle 1, z.B. von Zahl und Beabstandung der einzelnen Emitter, sowie vom Lasermedium 4, z.B. dessen Material, abhängen. Im allgemeinen wird der Homogenisator 3 eine schmalere Seite aufweisen, welche rein exemplarisch die Durchmischung durch multiple Reflexionen an dieser Fläche innerhalb des Stabes und in der Durchmischungsachse DA bewirkt, wohingegen in der breiteren Seite eine Fokussierung stattfinden kann. Hierfür können jedoch auch andere, von einem Quader bzw. Stab abweichende Geometrien erfindungsgemäss verwendet werden, wobei auch eine Durchmischung durch die breitere Seite bewirkt werden kann. Zur Gewährleistung verlustfreier Reflexionen bei der Durchmischung kann der Homogenisator 3 polierte oder beschichtete Seitenflächen aufweisen. Die Durch- oder Vermischung beruht dabei auf den durch die unterschiedliche Lage der Einzelemitter bedingten verschiedenen Einfallswinkel in den Homogenisator 3, wobei die Teilpumpstrahlengänge mit ihrer Divergenz durch eine Vielzahl von Reflexionen verschränkt und damit durchmischt werden.

Zusätzlich zur Durchmischung erfolgt in einer zur Durchmischungsachse DA senkrechten Projektionsachse PA eine direkte Projektion der von den Emittern der Laser-Pumpquelle 1 erzeugten Teilpumpstrahlen auf das Lasermedium 4, d.h. es erfolgt in dieser Achse keine der Durchmischungsachse DA entsprechende Durchmischung bzw. keine Beeinflussung der Strahldivergenz bzw. Strahlkonvergenz durch weitere Komponenten. Diese Projektion ist in der Fig.1A gestrichelt gezeigt. Damit wird die Emission der Laser-Pumpquelle 1 in der Projektionsachse PA mit der ursprünglichen - bzw. nur durch eine Mikrolinse auf dem Emitter beeinflußten - Divergenz durch den Homogenisator 3 unter Erhaltung der Strahldivergenz direkt auf das Lasermedium geführt. Hierzu werden die Teilpumpstrahlen über eine Einkopplungsoptik 2 in den Homogenisator 3 geführt, wobei diese Einkopplungsoptik 2 in der dargestellten Ausführungsform rein beispielhaft über zwei zylindrische Einkoppellinsen 2A und 2B verfügt, durch die neben der Projektion auf oder in das Lasermedium 4 sowohl die Sammlung und Einkopplung der Teilstrahlenbündel in den Homogenisator 3 als auch eine Beeinflussung der Durchmischung möglich ist.

Fig.1C zeigt ein zur Fig.1B analoges Ausführungsbeispiel, in dem durch Wahl einer anderen, z.B. in diesem Fall einer Mikrolinse mit vergleichsweise längerer Brennweite auf dem Emitter der Laser-Pumpquelle 1 eine geringere Divergenz in der Projektionsachse PA erzielt wird und dadurch der Pumpfleck im Lasermedium deutlich elliptischer ausgeführt wird.

Homogenisator 3 und Lasermedium 4 sind wiederum so ausgebildet und angeordnet, dass der aus dem Homogenisator 3 austretende und aus den durchmischten Teilpumpstrahlen zusammengesetzte Pumpstrahl auch in der Durchmischungsachse DA unmittelbar auf oder in das Lasermedium 4 geführt wird. Durch diese direkte und unmittelbare Einkopplung ohne weitere zwischengeschaltete strahlverändernde Komponenten wird optisch eine durchgehende Komponente aus Homogenisator 3 und Lasermedium 4 realisiert, wobei an der Übergangsstelle von Homogenisator 3 und Lasermedium 4 dabei für Durchmischungsachse DA und Projektionsachse PA eine Divergenzerhaltung erfolgt. Bei entsprechend geformten Lasermedium 4 ähnelt diese Anordnung damit einem durchgehend planaren Wellenleiter.

Hierbei können nachfolgend im Lasermedium 4 divergenzkompensierende Reflexionen erfolgen oder aber der Pumpstrahl wird hier ohne weitere Reflexion divergenzerhaltend weitergeführt. Im Falle von Reflexionen im Lasermedium 4 kann dieses zur Divergenzkompensation polierte oder beschichtete Seitenflächen aufweisen.

In diesem ersten Ausführungsbeispiel werden hierfür beide Komponenten so angeordnet, dass der Homogenisator 3 das Lasermedium 4 kontaktiert, wobei erfindungsgemäss neben dem unfixierten Aneinanderstoßen auch eine fixe Verbindung durch Kitten oder Diffusionsbonding möglich ist. Eine entsprechend mechanisch stabile Verbindung trägt zudem zur Robustheit der Anordnung bei und erlaubt den Verzicht auf den bei zwischengeschalteten Optiken erforderlichen Justageaufwand. Darüber hinaus bleibt die Homogenität des Pumpflecks erhalten, was im Falle einer zwischengeschalteten Optik eine besonders hochwertige und kostspielige Ausführung dieser Optik erfordert, um eine hochqualitative Abbildung trotz hoher Divergenzen zu erreichen. Abbildungsfehler bzw. Abberationen dieser Optik könnten ansonsten die Homogenität des Pumpflecks beeinträchtigen. Dabei hat die Homogenität des Pumpflecks direkten Einfluss auf die erzielte Strahlqualität bei hoher Strahlleistung, was für viele Anwendungen einen entscheidenden Parameter darstellt.

Je nach Lasermedium 4 kann nun das am Ausgang des Homogenisators 3 entstehende Strahlprofil bereits in Form und Größe im wesentlichen dem Pumpstrahlprofil im Lasermedium 4 entsprechen oder aber durch die Divergenz der Strahlung erst dort den erforderlichen Querschnitt annehmen.

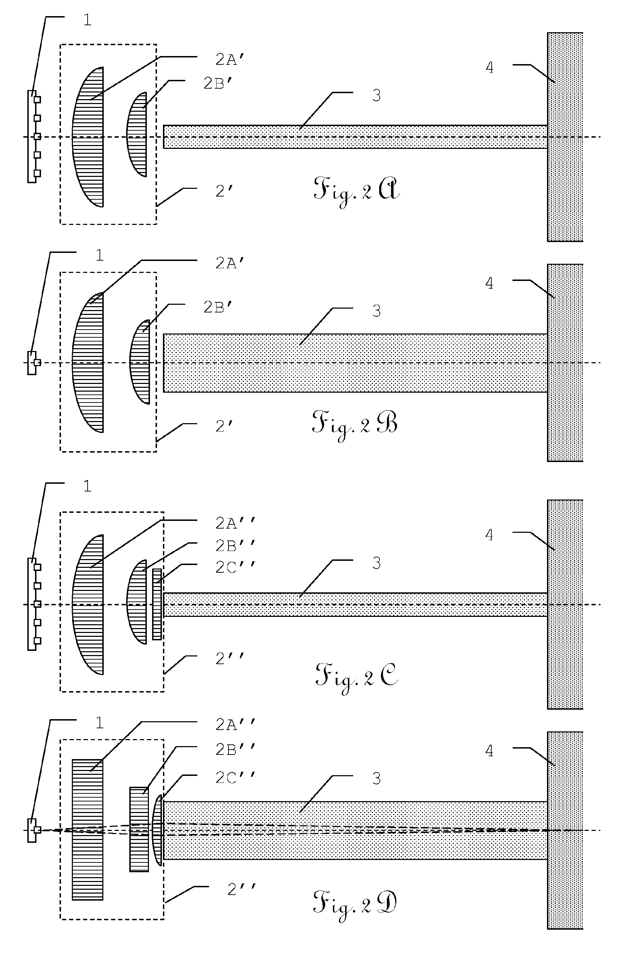

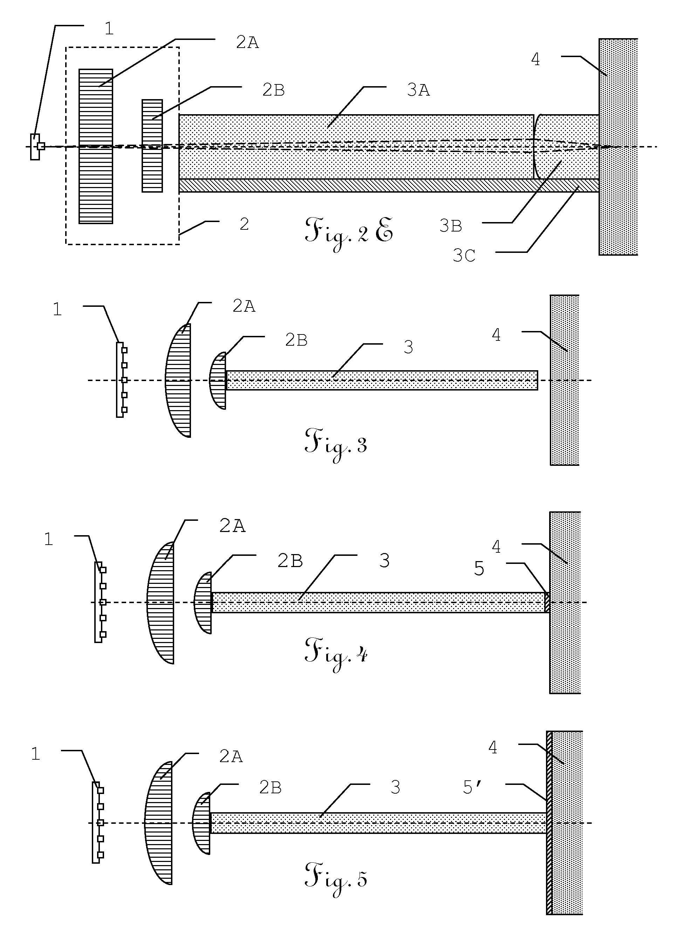

Fig.2 zeigt die schematische Darstellung eines zweiten Ausführungsbeispiels der erfindungsgemässen Pumpanordnung mit Varianten einer Fokussierung in der Projektionsachse. Im Vergleich zu Fig.1A-C wird ein grundsätzlich gleicher Aufbau und ein identischer Homogenisator 3 verwendet, wobei in den Fig.2A-B und in den Fig.2C-D jeweils verschiedene Varianten der Fokussierung dargestellt sind. In der Variante der Fig.2A-B weist die Einkopplungsoptik 2' nun zwei plankonvexe Einkoppellinsen 2A' und 2B" auf, wobei Einkopplungsoptik 2' auch zur Fokussierung in der Projektionsachse ausgelegt ist.

In diesem Aufbau erfolgt somit eine Durchmischung in der Durchmischungsachse bei gleichzeitiger Fokussierung in der hierzu senkrechten Projektionsachse. In der Variante der Fig.2C-D weist die Einkopplungsoptik 2" zwei zylindrische Einkoppellinsen 2A'' und 2B'' in Analogie zum Ausführungsbeispiel der Fig.1A-C auf, sowie zusätzlich eine in der Projektionsachse wirkende zylindrische Linse 2C''.

Erfindungsgemäss können sowohl der in der Projektionsachse die Strahldivergenz nicht beeinflussende wie auch der fokussierende Ansatz mit den nachfolgend dargestellten Ausführungsbeispielen kombiniert werden, so dass zumeist eine Darstellung in nur einer Achse erfolgt. Der Fachmann kann weitere erfindungsgemässe Beispiele für optische Abbildungssysteme ableiten, welche in der Durchmischungsachse die geeignete Abbildung in den Homogenisator erzeugt und gleichzeitig in der Projektionsachse einen geeigneten Pumpfleckradius im Lasermedium erzeugt und somit die gewünschte Elliptizität des Pumpflecks und Pumpintensität erreicht.

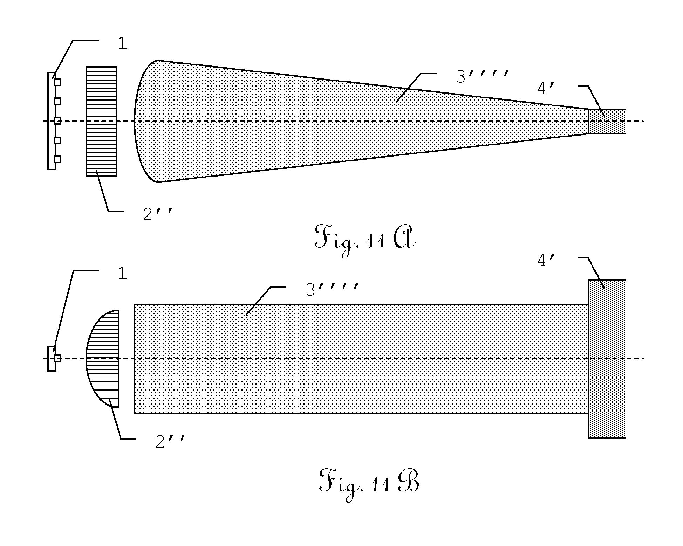

Auch kann die Einkopplungsoptik 2, 2' oder 2'' erfindungsgemäss ganz oder teilweise in den Homogenisator integriert werden, z.B. indem das Eintrittsfenster mit einer Wölbung versehen oder der Homogenisator aufgeteilt wird. Spezielle Beispiele hierfür werden in den Fig.2E und Fig.11A-B schematisch dargestellt, das Prinzip der Integration weiterer optischer Funktionen jenseits der reinen Durchmischung in den Homogenisator ist erfindungsgemäss aber auch auf andere Ausführungsbeispiele anwendbar. Allerdings kann dies einen erhöhten Aufwand auf der Komponentenseite bedingen, wohingegen eine getrennte Einkopplungsoptik die Verwendung von Homogenisatoren mit planaren Oberflächen erlaubt.

In der Variante der Fig.2E wird die Einkopplungsoptik 2 des ersten Ausführungsbeispiels aus Fig.1A-B mit zwei zylindrischen Einkoppellinsen 2A und 2B verwendet, jedoch ist nunmehr der Homogenisator in eine erste Homogenisatorkomponente 3A und eine zweite Homogenisatorkomponente 3B aufgeteilt, wobei diese durch eine Trägerkomponente 3C miteinander verbunden bzw. gegenseitig fixiert werden können. Die zweite Homogenisatorkomponente 3B ist so ausgebildet, dass sie neben der Durchmischung auch eine fokussierende Wirkung bereitstellt, wobei aber erste und zweite Homogenisatorkomponente 3A und 3B einen durchgehenden Homogenisator bilden.

Fig.3 zeigt die schematische Darstellung eines dritten Ausführungsbeispiels der erfindungsgemässen Pumpanordnung mit einem im Vergleich zu Fig.1A-C oder Fig.2A-E grundsätzlich gleichen Aufbau. Wie auch in den folgenden Figuren 4-6 ist hierbei nur die Draufsicht, d.h. die Durchmischungsachse gezeigt, so dass sowohl die direkte Projektion ohne Fokussierung gem. Fig.1A-C oder die Projektion mit Fokussierung gem. Fig.2A-E erfindungsgemäss für die Projektionsachse realisierbar sind. In dieser Ausführungsform berühren sich Homogenisator 3 und Lasermedium 4 nicht, sondern sind mit geringfügigem Abstand zueinander positioniert. Der entsprechende Abstand von Homogenisator 3 und Lasermedium 4 kann dabei kleiner als der kleinste Durchmesser eines Querschnitts des austretenden Pumpstrahls oder kleiner als die kleinste Kantenlänge des Homogenisators 3 gewählt werden, insbesondere kann dieser zwischen 100 und 880 µm, beispielsweise 300 oder 500 µm, betragen.

Ein viertes Ausführungsbeispiels der erfindungsgemässen Pumpanordnung wird Fig.4 gezeigt, bei dem Homogenisator 3 und Lasermedium 4 miteinander in Verbindung stehen. Allerdings ist an der Kontaktstelle zwischen diesen beiden Komponenten eine transmissionserhöhende Schicht 5 angeordnet, die in diesem Beispiel bei der Fertigung auf den Homogenisator 3 aufgebracht wurde. Eine solche transmissionserhöhende Schicht 5 ist jedoch nicht in allen Fällen erforderlich, z.B. kann darauf verzichtet werden, wenn die Brechungsindizes der beiden für Homogenisator 3 und Lasermedium 4 verwendeten Materialien nah beieinander liegen.

Wird das Lasermedium 4 als Spiegelelement, z.B. zur Strahlfaltung im Resonator oder als Endspiegel, verwendet, so kann die zu verstärkende Laserstrahlung von der dem Homogenisator 3 gegenüberliegenden Seite in das Lasermedium 4 geführt werden. In diesem Fall kann die transmissionserhöhende Schicht 5' vollflächig auf die dem Homogenisator 3 zugewandte Fläche des Lasermediums 4 aufgebracht werden, wobei diese für als Nutzsignal zu verstärkende Laserstrahlung reflektierend, für die Pumpstrahlung aber transmittierend ausgelegt ist. Dies kann beispielsweise durch eine spektral selektive Reflexions- bzw. Transmissionswirkung für die unterschiedlichen Wellenlängen von Pump- und Nutzsignalstrahlung erreicht werden, so dass eine optimale Einkopplung der Pumpstrahlung bei Reflexion der zu verstärkenden Laserstrahlung im Lasermedium 4 erfolgt. Dieser Fall wird in Fig.5 als ein fünftes Ausführungsbeispiel dargestellt.

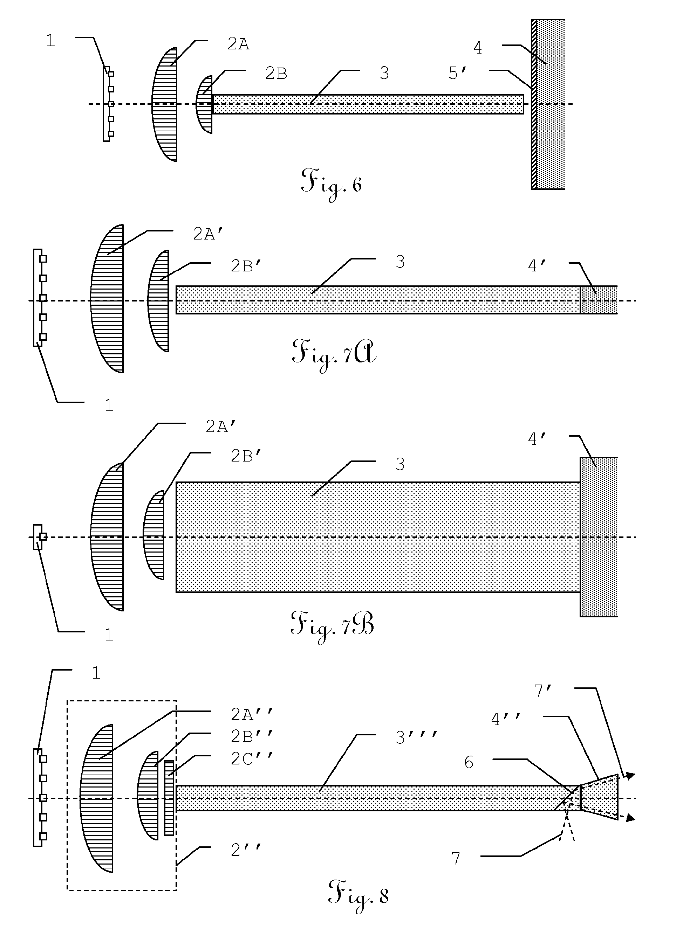

Ein sechstes Ausführungsbeispiel der erfindungsgemässen Pumpanordnung wird schliesslich in Fig.6 gezeigt, bei dem die Merkmale der vollflächig auf das Lasermedium 4 aufgebrachten transmissionserhöhenden und spektral selektiv reflektierenden Schicht 5' mit einer Beabstandung des Homogenisators 3 verbunden ist.

Fig.7A-B zeigt schematisch ein siebtes Ausführungsbeispiel der erfindungsgemässen Pumpanordnung, wiederum mit Darstellung von Projektions- und Durchmischungsachse. Dabei entspricht der Aufbau im Prinzip dem zweiten Ausführungsbeispiel gem. Fig.2A-B mit einer Fokussierung in der Projektionsachse. Allerdings sind in diesem Ausführungsbeispiel das Lasermedium 4' und Homogenisator 3 so aufeinander abgestimmt, dass das Lasermedium 4' in Fortsetzung des Homogenisators 3 zumindest in der Durchmischungsachse als Wellenleiter wirkt. Dabei kann auch - in Abweichung vom gezeigten Ausführungsbeispiel - in der Projektionsachse eine Anpassung von Homogenisatorquerschnitt und Querschnitt des Lasermediums 4' erfolgen.

Fig.8 zeigt ein achtes Ausführungsbeispiel der erfindungsgemässen Pumpanordnung, wobei nur die Durchmischungsachse dargestellt ist. Der Aufbau der Einkopplungsoptik 2" gleicht dabei der in Fig.2C-D dargestellten Anordnung, allerdings wird in diesem Ausführungsbeispiel eine Beschichtung 6 in den Homogenisator 3" ' eingebracht, welche für die Pumpstrahlung durchlässig und für die Strahlung des Nutzsignals 7 reflektierend ist. Das Nutzsignal 7 wird hierfür seitlich in den Homogenisator 3''' eingekoppelt und nach Verstärkung in einem in diesem Ausführungsbeispiel trapezförmigen Lasermedium 4'' als verstärkter Ausgangsstrahl 7' emittiert. Diese Verstärkeranordnung kann beispielsweise zur externen Nachverstärkung von Laserstrahlen oder aber auch zur Resonator-internen Verstärkung verwendet werden.

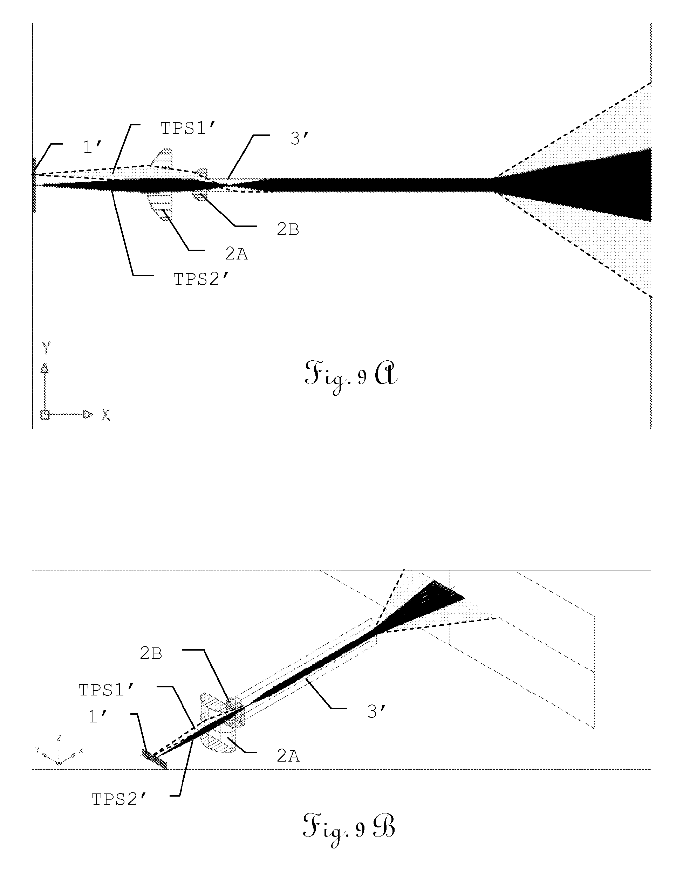

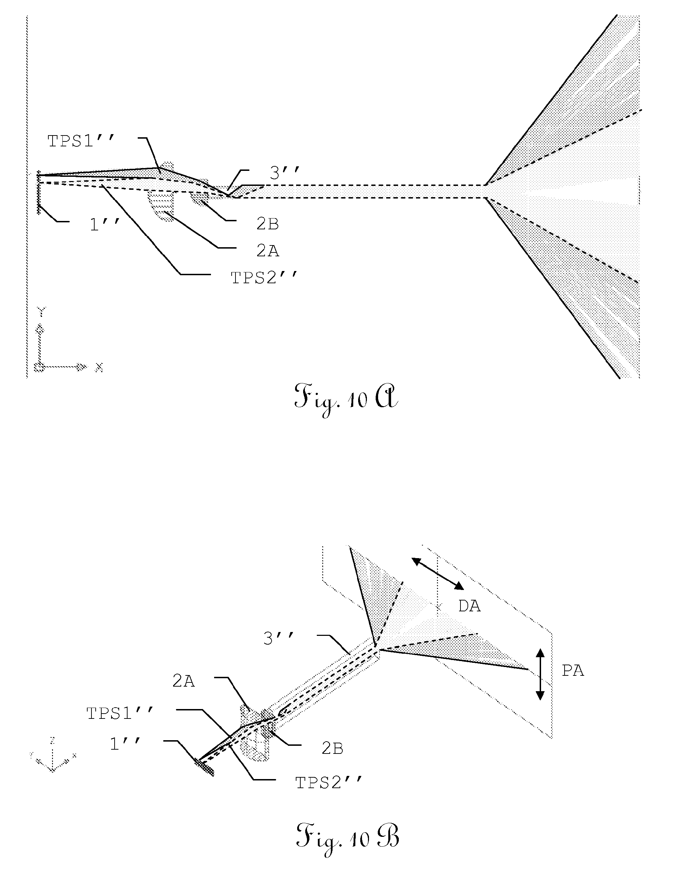

Die in den Fig.9A-D und 10A-D gezeigten Beispiele sind mittels Ray-Tracing erstellt worden, wobei aus Veranschaulichungsgründen bewusst auf die erfindungsgemäss ebenfalls mögliche Fokussierung in der nicht homogenisierenden Ebene verzichtet wurde. In beiden Beispielen werden als Einkoppellinsen 2A und 2B Linsen des Herstellers Thorlabs vom Typ LJ1095L1-B sowie LJ1874L1-B verwendet, wobei die erste Linse LJ1095L1-B im Abstand von d₁ = 28 mm von der Laser-Pumpquelle 1' und die zweite Linse LJ1874L1-B von der ersten in einem Abstand von d₂ = 4,5 mm plaziert ist. Der Abstand von zweiter Linse LJ1874L1-B zum Homogenisator 3' beträgt d₃ = 0,3 mm.

In Fig.9A-D werden zwei Teilpumpstrahlen TPS1' und TPS2' für den in der Mitte und den an einer Kante liegenden Emitter eines Laserdiodenstapels von 5 mm Breite als Laser-Pumpquelle 1' berechnet. Der halbe Winkel der Divergenz in der Slow-Axis beträgt 3-4° und der Homogenisator 3' ist als Quarzglas-Stab mit einer Länge von 70 mm und einer Breite von 3 mm in der Durchmischungsachse ausgebildet. Erläutert wird das erfindungsgemässe Pumpverfahren anhand eines ersten Beispiels für den Strahlgang der erfindungsgemässen Pumpanordnung. Durch zwei unterschiedliche und voneinander beabstandete Emitter der Laser-Pumpquelle 1' werden Teilpumpstrahlen TPS1' und TPS2' zum Pumpen des Lasermediums 4 erzeugt und durch eine nachgeordnete Einkoppeloptik aus zwei Zylinderlinsen als Einkoppellinsen 2A und 2B in den Homogenisator 3' geführt, wobei wenigstens eine zylindrische Einkoppellinse mit ihrer Längsachse in Richtung der Achse der Durchmischung orientiert ist. Dort erfolgt ein Durchmischen der Teilpumpstrahlen TPS1' und TPS2' in wenigstens einer Achse durch multiple Reflexionen, so dass ein Pumpstrahl für das Lasermedium 4 aus den durchmischten Teilpumpstrahlen TPS1' und TPS2' erzeugt wird. In dieser Figur sind rein aus Veranschaulichungsgründen nur zwei Teilpumpstrahlen TPS1' und TPS2' dargestellt. Erfindungsgemäss werden jedoch die Emissionen einer grösseren Zahl von Emittern durchmischt. Beim Erzeugen des Pumpstrahls für das Lasermedium werden die Teilpumpstrahlen TPS1' und TPS2' nach dem Durchmischen direkt auf oder in das Lasermedium 4 geführt. Durch unterschiedliche Divergenzen in den beiden Achsen der durchmischten Teilpumpstrahlen TPS1' und TPS2' kann beispielsweise ein elliptisches Strahlprofil des Pumpstrahls erzeugt wird. Dies wird dadurch bewirkt, dass der Homogenisator 3' eine Dimensionierung aufweist, welche ein elliptisches Strahlprofil des austretenden Pumpstrahls erzeugt, insbesondere durch die gezielte Erzeugung oder Erhaltung von unterschiedlichen Strahldivergenzen in den beiden Achsen, wobei je nach Anwendungszweck bzw. verwendeten Lasermedium 4 eine vollständige oder auch nur teilweise Durchmischung in der Breite des elliptischen Strahlprofils erfolgen kann.

Wie aus Fig.9B ersichtlich, weist der Pumpstrahl am Ausgang des Homogenisators 3' eine hohe Divergenz in dieser Achse auf. Die Divergenz in der anderen Achse kann unbeeinflusst durch den Homogenisator 3' bleiben, so dass ein elliptischer Pumplichtfleck entsteht. Erfindungsgemäss kann jedoch auch eine Fokussierung erfolgen, so dass auch Pumplichtflecke bzw. Strahlquerschnitte des Pumpstrahls an einen gewünschten Querschnitt bzw. ein Strahlprofil angepasst werden können, die mehr oder weniger elliptisch sind.

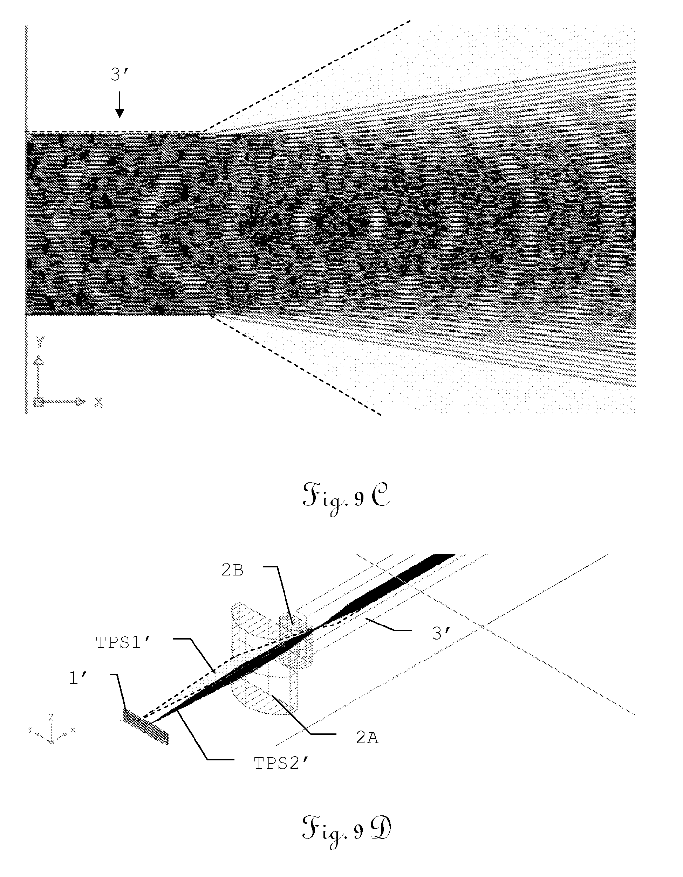

Fig.9C zeigt die Divergenz in der Durchmischungsachse am Ende des Homogenisators 3' im Detail. Fig.9D erläutert die Einkoppeloptik mit den beiden Einkoppellinsen 2A und 2B in Vergrösserung.

Fig.10A-D zeigt die Darstellung eines zweiten Beispiels für den Strahlgang der erfindungsgemässen Pumpanordnung. Als die zwei Teilpumpstrahlen TPS1'' und TPS2" erzeugende Laser-Pumpquelle 1'' dient ein Laserdiodenstapel von 10 mm Breite, bei dem wiederum die Emissionen von in der Mitte und den an einer Kante liegenden Emittern betrachtet wird. Der halbe Winkel der Divergenz in der Slow-Axis beträgt 3-4° und der Homogenisator 3'' ist als Quarzglas-Stab mit einer Länge von 160 mm und einer Breite von 7 mm in der Durchmischungsachse ausgebildet.

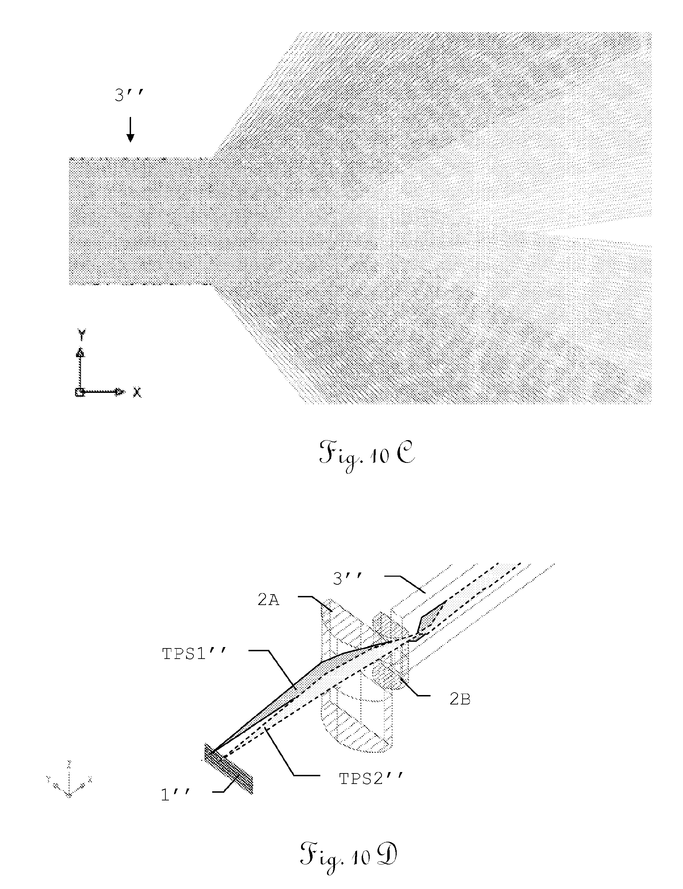

Wie auch beim in Fig.10B dargestellten ersten Beispiel weist auch in diesem Fall der Pumpstrahl am Ausgang des Homogenisators 3'' eine hohe Divergenz in der Durchmischungsachse DA bei geringer Divergenz in der Projektionsachse PA auf, so dass ein elliptischer Pumplichtfleck entsteht. Fig.10C zeigt diese Divergenz der Durchmischungsachse am Ende des Homogenisators 3'' im Detail. Fig.10D erläutert die Einkoppeloptik mit den beiden Einkoppellinsen 2A und 2B in Vergrösserung.

In Fig.11A-B wird ein achtes Ausführungsbeispiel der erfindungsgemässen Pumpanordnung schematisch dargestellt, bei dem ein in der Durchmischungsachse mit einem Öffnungswinkel versehener Homogenisator 3'''' verwendet wird. Hierbei ist der Öffnungswinkel an die Divergenz angepasst, wobei zudem das Eintrittsfenster eine gewölbte Form aufweist, so dass ein Linseneffekt erzielt wird. In diesem Ausführungsbeispiel wird somit eine Teil der Funktionalität der Einkopplungsoptik in den Homogenisator 3'''' verlegt. In der Projektionsachse erfolgt durch eine Zylinderlinse 2" eine Fokussierung, so dass die in dieser Achse zu erzielende Pumpfleckgeometrie direkt erzeugt wird.

Es versteht sich, dass die dargestellten Pumpanordnung bzw. gepumpte Lasersysteme nur Ausführungsbeispiele von vielen erfindungsgemäss realisierbaren Ausführungsformen darstellen und der Fachmann alternative Realisierungsformen des Pump- und Laseraufbaus, z.B. unter Verwendung anderer Linsenparameter oder -anordnungen, Homogenisatortypen oder gepumpten Medien, wie z. B. Scheibenlaser, ableiten kann.

## Patentansprüche

1. Laserpumpanordnung zur Erzeugung elliptischer Pumpgeometrien für ein Laserstrahlung verstärkendes Lasermedium (4,4',4'') mit mindestens
• einer Laser-Pumpquelle (1,1',1'') mit mehreren Emittern zur Erzeugung von Teilpumpstrahlen (TPS1,TPS2,TPS1',TPS1'',TPS2',TPS2''), insbesondere Laserdioden, zum Pumpen des Lasermediums (4,4',4''),
• einem optischen Homogenisator (3,3',3'',3''',3'''') zur Durchmischung der Teilpumpstrahlen (TPS1, TPS2, TPS1', TPS1'', TPS2', TPS2'') in einer Durchmischungsachse (DA) durch multiple Reflexionen,
• einer Einkopplungsoptik (2,2',2'') zwischen Laser-Pumpquelle (1,1',1'') und Homogenisator (3,3',3'',3''',3''''),
**dadurch gekennzeichnet, dass**
- die Einkopplungsoptik (2,2', 2'') so ausgebildet und angeordnet ist, dass die Teilpumpstrahlen (TPS1, TPS2, TPS1', TPS1'', TPS2', TPS2'') in einer zur Durchmischungsachse (DA) senkrechte Projektionsachse (PA) direkt auf oder in das Lasermedium (4,4', 4'') projiziert, insbesondere fokussiert werden und
- Homogenisator (3, 3', 3'', 3''', 3'''') und Lasermedium (4, 4', 4'') so ausgebildet und angeordnet sind, dass der aus dem Homogenisator (3, 3', 3'', 3''', 3'''') austretende Pumpstrahl unter Divergenzerhaltung für die Durchmischungsachse (DA) unmittelbar auf oder in das Lasermedium (4,4',4'') geführt wird.

2. Laserpumpanordnung nach Anspruch 1,
**dadurch gekennzeichnet, dass**
der Homogenisator (3, 3', 3'', 3''', 3'''') eine Dimensionierung aufweist, welche ein elliptisches Strahlprofil des austretenden Pumpstrahls erzeugt, insbesondere durch unterschiedliche Strahldivergenzen in Durchmischungsachse (DA) und Projektionsachse (PA).

3. Laserpumpanordnung nach Anspruch 2,
**dadurch gekennzeichnet, dass**
das Strahlprofil in Form und Größe im wesentlichen dem Pumpstrahlprofil im Lasermedium (4, 4', 4'') entspricht.

4. Laserpumpanordnung nach Anspruch 2 oder 3,
**dadurch gekennzeichnet, dass**
eine vollständige Durchmischung in der Breite des elliptischen Strahlprofils erfolgt.

5. Laserpumpanordnung nach einem der Ansprüche 1 bis 4,
**dadurch gekennzeichnet, dass**
der Abstand von Homogenisator (3, 3', 3'', 3''', 3'''') und Lasermedium (4,4',4'') kleiner als
- der kleinste Durchmesser eines Querschnitts des austretenden Pumpstrahls oder
- die kleinste Kantenlänge des Homogenisators (3, 3', 3'',3'''', 3'''')
ist, insbesondere zwischen 100 und 880µm beträgt.

6. Laserpumpanordnung nach einem der Ansprüche 1 bis 4,
**dadurch gekennzeichnet, dass**
der Homogenisator (3, 3', 3'', 3'', 3'''') das Lasermedium (4, 4', 4'') kontaktiert, insbesondere mit diesem verbunden ist.

7. Laserpumpanordnung nach einem der vorangehenden Ansprüche,
**dadurch gekennzeichnet, dass**
zwischen Homogenisator (3, 3', 3'', 3''', 3'''') und Lasermedium (4, 4', 4'') eine transmissionserhöhende Schicht (5, 5') angeordnet ist.

8. Laserpumpanordnung nach Anspruch 7,
**dadurch gekennzeichnet, dass**
die transmissionserhöhende Schicht (5,5') für die zu verstärkende Laserstrahlung reflektierend ist, insbesondere durch eine spektral selektive Reflexion.

9. Laserpumpanordnung nach einem der vorangehenden Ansprüche,
**dadurch gekennzeichnet, dass**
der Homogenisator (3, 3', 3'', 3''', 3''') zur Erzeugung der Durchmischung der Teilpumpstrahlen (TPS1, TPS2,TPS1', TPS1'', TPS2', TPS2'') in wenigstens der Durchmischungsachse (DA) polierte oder beschichtete Seitenflächen aufweist.

10. Laserpumpanordnung nach einem der vorangehenden Ansprüche,
**dadurch gekennzeichnet, dass**
die Einkopplungsoptik (2, 2', 2'') wenigstens eine zylindrische Einkoppellinse (2A, 2B) aufweist, wobei deren Längsachse senkrecht zur Durchmischungsachse (DA) orientiert ist.

11. Laserpumpanordnung nach Anspruch 10,
**dadurch gekennzeichnet, dass**
die wenigstens eine zylindrische Einkoppellinse (2A, 2B) so ausgebildet und angeordnet ist, dass Strahldivergenzen der Teilpumpstrahlen (TPS1, TPS2, TPS1', TPS1'', TPS2', TPS2'') in der Durchmischungsachse (DA) wenigstens erhalten oder vergrößert, insbesondere maximiert werden.

12. Lasersystem mit einem Lasermedium (4, 4', 4'') in einem Resonator zur Verstärkung von Laserstrahlung und einer Laserpumpanordnung nach einem der Ansprüche 1 bis 11.

13. Lasersystem nach Anspruch 12,
**dadurch gekennzeichnet, dass**
das Lasermedium (4, 4', 4'') zur Divergenzkompensation polierte oder beschichtete Seitenflächen aufweist.

14. Laserpumpverfahren zur Erzeugung elliptischer Pumpgeometrien für ein Laserstrahlung
verstärkendes Lasermedium mit
• einem Emittieren von Teilpumpstrahlen (TPS1,TPS2,TPS1',TPS1'',TPS2',TPS2'') zum Pumpen des Lasermediums (4, 4', 4''),
• einem Durchmischen der Teilpumpstrahlen (TPS1, TPS2, TPS1', TPS1'', TPS2', TPS2'') in einer Durchmischungsachse (DA) durch multiple Reflexionen in einem Homogenisator (3, 3', 3'', 3''', 3''''),
• einem Erzeugen eines Pumpstrahls für das Lasermedium (4, 4', 4'') aus den durchmischten Teilpumpstrahlen (TPS1', TPS1'', TPS2', TPS2''),
**dadurch gekennzeichnet, dass**
beim Erzeugen des Pumpstrahls die Teilpumpstrahlen (TPS1, TPS2, TPS1', TPS1'', TPS2', TPS2'')
- in einer zur Durchmischungsachse (DA) senkrechte Projektionsachse (PA) direkt auf oder in das Lasermedium (4, 4', 4'') projiziert, insbesondere fokussiert und
- nach dem Durchmischen unter Divergenzerhaltung in der Durchmischungsachse (DA) direkt auf oder in das Lasermedium (4, 4', 4'') geführt werden.

15. Laserpumpverfahren nach Anspruch 14,
**dadurch gekennzeichnet, dass**
beim Erzeugen durch unterschiedliche Divergenzen der durchmischten Teilpumpstrahlen (TPS1, TPS2, TPS1', TPS1'', TPS2', TPS2'') in der Durchmischungsachse (DA) und der Projektionsachse (PA) ein elliptisches Strahlprofil des Pumpstrahls erzeugt wird.
